# FASCICULE DE BREVET EUROPEEN

(11) **EP 1 901 397 B1**
(45) Date de publication et mention de la délivrance du brevet: **30.03.2016**
(21) Numéro de dépôt: 07116332.3
(22) Date de dépôt: 13.09.2007
(51) Int. Cl.: H01R 12/79, H01R 12/77, H01R 12/62, H05K 1/02, H05K 13/08, H05K 1/11, H01R 12/70, H01R 13/58

(54) **Dispositif de connexion électrique**
Elektrische Verbindungseinrichtung
Electrical connecting device

(30) Priorité: 15.09.2006 FR 0608088
(43) Date de publication de la demande: 19.03.2008
(73) Titulaire: MAGNETI MARELLI FRANCE, 78190 Trappes (FR)
(72) Inventeur: Angot, Maxime, 86100, CHATELLERAULT (FR)
(74) Mandataire: Regimbeau

(56) Documents cités:
- WO-A1-99/57954
- DE-U1- 8 603 269
- US-A- 5 237 622

## Description

La présente invention concerne le domaine des dispositifs de connexion électrique.

La présente invention s'applique en particulier, mais non exclusivement, au domaine de la connexion électrique de modules à fonction électrique sur véhicules automobiles.

La présente invention s'applique tout particulièrement, mais non exclusivement, à la connexion électrique à base de bandes flexibles ou souples portant plusieurs pistes électriquement conductrices.

De nombreux moyens de connexion électrique entre sous ensembles à fonction électrique ont déjà été proposés. On connaît en particulier depuis plusieurs années des moyens de connexion formés d'une bande support flexible électriquement isolante en matériau plastique qui porte des pistes électriques électriquement conductrices parallèles.

Les dispositifs de connexion électrique à base de bandes flexibles présentent l'intérêt d'une grande liberté de positionnement relatif entre les sous ensembles ainsi reliés, y compris une possibilité de déplacement relatif, par exemple après établissement d'une connexion et la réalisation de tests, avant le positionnement relatif définitif des sous ensembles.

Le document DE 86 03 269 U1 décrit un dispositif de connexion électrique comprenant une bande support électriquement isolante portant des pistes électriquement conductrices aptes à être insérée dans un connecteur électrique complémentaire, par une ouverture d'engagement, la bande comprenant au moins une structure de maintien apte à entourer au moins partiellement le côté du connecteur opposé à l'ouverture d'engagement.

Cependant, la Demanderesse a constaté que les dispositifs de connexion électrique jusqu'ici connus ne donnent pas toujours totalement satisfaction, notamment sur le plan fiabilité, et ce tout particulièrement dans le domaine automobile.

La présente invention a pour but d'améliorer la situation.

Ce but est atteint dans le cadre de la présente invention, grâce à un dispositif de connexion électrique comprenant conforme à la revendication 1 annexée.

Selon une caractéristique avantageuse de la présente invention, la structure de maintien est formée d'une boucle.

D'autres caractéristiques, buts et avantages de la présente invention apparaîtront à la lecture de la description détaillée qui va suivre, et en regard des dessins annexés, donnés à titre d'exemples non limitatifs et sur lesquels :
- la figure 1 représente une vue partielle schématique en perspective d'un ensemble de connexion conforme à la présente invention comprenant une bande flexible engagée dans un connecteur complémentaire,
- la figure 2 représente une vue similaire du seul connecteur porté par un circuit imprimé,
- la figure 3 représente une vue similaire de la seule bande de connexion,
- la figure 4 représente une vue en plan du même dispositif, et
- les figures 5 et 6 représentent des vues similaires à la figure 3 de deux variantes de réalisation conformes à la présente invention.

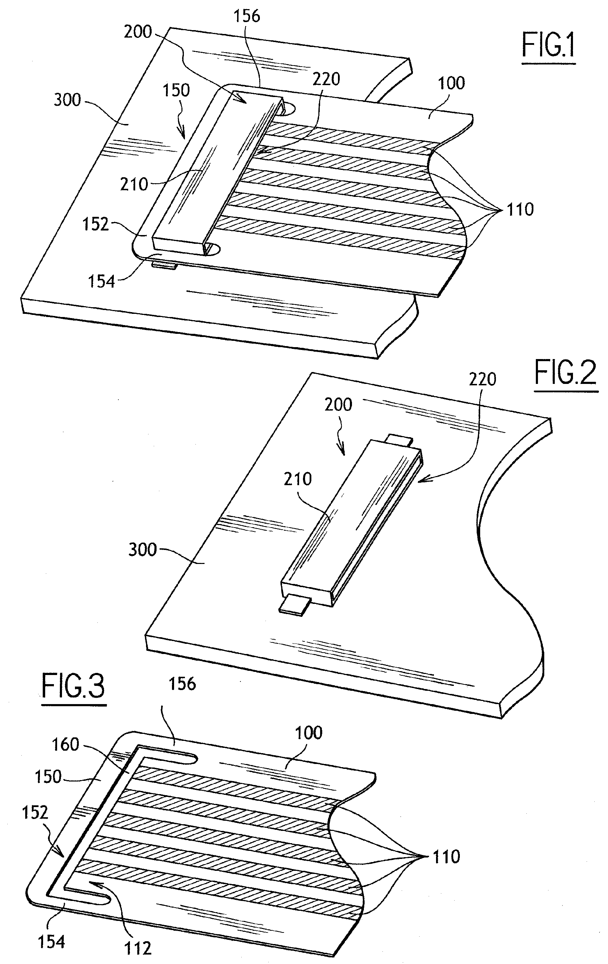

On aperçoit sur la figure 1 annexée, une bande de connexion 100 apte à coopérer avec un connecteur complémentaire 200.

La structure de base ainsi formée comprenant une bande de liaison multipistes 100 et un connecteur 200 complémentaire, est bien connu de l'homme de l'art et ne sera pas décrite dans le délai par la suite.

L'homme de l'art connaît en effet de nombreux connecteurs 200 formés d'un corps rigide 210 adapté pour être fixé par tout moyen approprié sur un support adapté 300, par exemple une plaquette de circuit imprimé ou tout moyen équivalent. Un tel connecteur 210 loge différents contacts électriquement conducteurs conçus pour être reliés respectivement à des pistes portées par le support 300 ou circuit imprimé. Les mêmes contacts électriquement conducteurs logés dans le boîtier 210 sont adaptés pour venir respectivement en prise avec les pistes 110 électriquement conductrices, parallèles entre elles, portées par la bande support 100.

Pour se faire, le boîtier 210 de connecteur 200 comporte une ouverture d'engagement 220 au niveau de laquelle les contacts électriques internes du connecteur 200 sont accessibles et aptes à recevoir une extrémité de la bande support 100.

La bande support 100 est elle-même formée d'une feuille allongée, typiquement en matière plastique, qui porte une pluralité de pistes 110 électriquement conductrices, parallèles entre elles, par exemple en cuivre ou tout matériau équivalent.

Bien entendu l'invention n'est pas limitée au mode de réalisation particulier, tant pour la bande support 100 que pour le connecteur 200, représenté sur les figures annexées.

Selon la présente invention, comme indiqué précédemment, l'extrémité de la bande 100 destinée à coopérer avec le connecteur 200 est munie d'une structure de maintien 150 qui entoure au moins partiellement le côté du connecteur 210 opposé à l'ouverture d'engagement 220. De préférence, comme représenté sur la figure 3, la structure de maintien 150 est formée d'une boucle fermée comprenant une bande 152 qui s'étend transversalement à la direction d'élongation des pistes 110 et reliée par deux branches qui lui sont perpendiculaires, 154, 156 aux tranches latérales de la bande support 100. Une telle structure de maintien 150 remplit plusieurs fonctions.

Elle permet tout d'abord de garantir le maintien de l'extrémité de la bande 100 dans le connecteur 200. L'homme de l'art comprendra en effet qu'une fois la boucle 150 passée au delà du corps de connecteur 210, celle-ci interdit tout retrait intempestif de la bande 100 par translation perpendiculairement au plan du contour d'engagement 220. Une telle fonction de maintien est particulièrement importante dans le domaine des véhicules automobiles où les modules électroniques sont soumis à des vibrations ou accélérations importantes.

La boucle 150 remplit une deuxième fonction. Elle permet en effet également de garantir la mise en place correcte de la bande 100 sur le corps de connecteur 200. Il suffit en effet pour cela de tester soit visuellement, soit par tout moyen automatique optique approprié le positionnement correct de la bande 152 pour assurer la mise en place correcte de la bande de liaison électrique 100 (orientation, engagement, etc ...).

De tels moyens de contrôle optique ne sont pas représentés sur les figures annexées et sont bien connus de l'homme de l'art. La structure de maintien 150 comporte au moins sur une zone donnée une sérigraphie appropriée, par exemple une bande opaque.

L'on notera que la structure de maintien 150 permet de garantir le positionnement correct de la bande 100 dans le connecteur 200 y compris après mise en place du circuit imprimé 300 ou d'un module relié à l'autre extrémité de la bande 100, c'est-à-dire après déplacement relatif entre ces deux sous ensembles pour autoriser leur implantation requise définitive.

Plus précisément encore, on notera que de préférence la bande 100 comporte une zone 112 d'extrémité en saillie dans la boucle 150, laquelle zone 112 est adaptée pour pénétrer dans le contour d'engagement 220, les bandes de liaison 154, 156 étant disposées de part et d'autre du corps de connecteur 200 sur l'extérieur de celui-ci. Ainsi, la zone 112 en avancée dans la boucle 150 délimite une découpe 160 en forme de U entre elle-même et le matériau constituant la boucle 150.

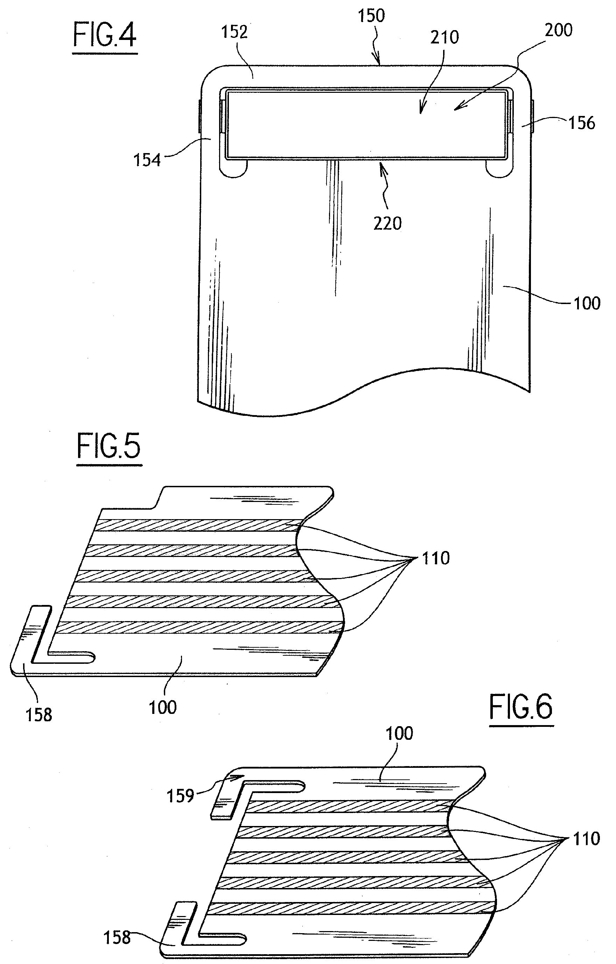

Comme on l'a représenté sur la figure 5, en variante, la boucle 150 représentée sur la figure 3 peut être remplacée par un simple crochet 158 apte à entourer une partie du côté de connecteur 200 opposé à l'ouverture d'engagement 220. Selon encore une autre variante représenté sur la figure 6, le moyen de maintien 150 représenté sur la figure 3 peut être remplacé par deux crochets 158, 159 adaptés également pour entourer respectivement au moins une partie du corps de connecteur 200 opposé à l'ouverture d'engagement 220.

Les variantes représentées sur les figures 5 et 6 remplissent également les deux fonctions décrites précédemment, à savoir à la fois garantir le maintien de la bande support 100 assurant une fonction électrique, dans son positionnement correct par rapport au corps de connecteur 200 d'une part, et une fonction de test de positionnement optique de la bande 100 d'autre part.

## Revendications

1. Dispositif de connexion électrique comprenant une bande support électriquement isolante (100) portant des pistes électriquement conductrices (110) apte à être insérée dans un connecteur électrique complémentaire (200), par une ouverture d'engagement (220), la bande (100) comprenant au moins une structure de maintien (150) apte à entourer au moins partiellement un côté du connecteur (200) opposé à l'ouverture d'engagement (220), **caractérisé par le fait que** la structure de maintien comprend au moins une zone sérigraphiée, pour assurer également une fonction de test de positionnement optique.

2. Dispositif selon la revendication 1, **caractérisé par le fait que** la structure de maintien (150) est formée d'une boucle.

3. Dispositif selon la revendication 1, **caractérisé par le fait que** la structure de maintien comprend au moins un crochet (158).

4. Dispositif de maintien selon l'une des revendications 1 ou 3, **caractérisé par le fait que** la structure de maintien (150) comprend deux crochets (158, 159).

5. Dispositif selon l'une des revendications 1 à 4, **caractérisé par le fait que** la bande support (100) est formée en matériau plastique et porte une pluralité de pistes (110) électriquement conductrices en métal.

## Patentansprüche

1. Vorrichtung zum elektrischen Anschluss, umfassend ein elektrisch nicht leitendes Trägerband (100), das elektrisch leitende Bahnen (110) trägt, dafür geeignet, durch eine Einstecköffnung (220) in einen komplementären elektrischen Steckverbinder (200) eingefügt zu werden, wobei das Band (100) mindestens eine Sicherungsstruktur (150) aufweist, dafür geeignet, eine Seite des Steckverbinders (200) gegenüber der Einstecköffnung (220) mindestens teilweise zu umschließen, **dadurch gekennzeichnet, dass** die Sicherungsstruktur mindestens einen mit einem Rasterdruck versehenen Bereich aufweist, um gleichermaßen eine Funktion der optischen Positionierungsprüfung sicherzustellen.

2. Vorrichtung nach Anspruch 1, **dadurch gekennzeichnet, dass** die Sicherungsstruktur (150) von einer Schlaufe gebildet wird.

3. Vorrichtung nach Anspruch 1, **dadurch gekennzeichnet, dass** die Sicherungsstruktur mindestens einen Haken (158) aufweist.

4. Vorrichtung nach einem der Ansprüche 1 oder 3, **dadurch gekennzeichnet, dass** die Sicherungsstruktur (150) zwei Haken (158, 159) aufweist.

5. Vorrichtung nach einem der Ansprüche 1 bis 4, **dadurch gekennzeichnet, dass** das Trägerband (100) aus Kunststoff ist und eine Vielzahl elektrisch leitender Bahnen (110) aus Metall trägt.

## Claims

1. Electrical connecting device comprising an electrically insulating carrier strip (100) carrying electrically conducting tracks (110), capable of being inserted into an additional electrical connector (200), by an engaging opening (220), the strip (100) comprising at least one holding structure (150) capable of at least partially surrounding one side of the connector (200) opposite the engaging opening (220), **characterised in that** the holding structure comprises at least one screen printed area to further perform an optical positioning test function.

2. Device according to claim 1, **characterised in that** the holding structure (150) is formed from a loop.

3. Device according to claim 1, **characterised in that** the holding structure comprises at least one hook (158).

4. Holding device according to one of claims 1 to 3, **characterised in that** the holding structure (150) comprises two hooks (158, 159).

5. Device according to one of claims 1 to 4, **characterised in that** the carrier strip (100) is made from a plastic material and carries a plurality of metal, electrically conducting tracks (110).
